# EUROPÄISCHE PATENTANMELDUNG

(11) **EP 1 381 094 A2**
(43) Veröffentlichungstag der Anmeldung: **14.01.2004**
(21) Anmeldenummer: 03015291.2
(22) Anmeldetag: 07.07.2003
(51) Int. Cl.: H01L 41/24, H01L 41/083

(54) **Isolierung für piezokeramische Vielschichtaktoren**

(30) Priorität: 11.07.2002 DE 10231536
(71) Anmelder: Ceramtec AG, 73207 Plochingen (DE)
(72) Erfinder: Schreiner, Hans-Jürgen, 91233 Neunkirchen am Sand-Rollhofen (DE); Schmieder, Jürgen, 91207 Lauf (DE); Bindig, Reiner, 95463 Bindlach (DE)
(74) Vertreter: Scherzberg, Andreas, Dr.

(57) **Zusammenfassung**

Die Erfindung betrifft ein Verfahren zur Herstellung piezoelektrischer Vielschichtaktoren, bei dem dünne Schichten aus einem piezokeramischen Werkstoff, Grünfolien genannt, auf die mindestens eine Innenelektrode aufgebracht sind, so zu einem Block aufeinandergestapelt werden, dass die Innenelektroden alternierend an sich gegenüberliegenden Flächen des Aktors geführt werden, wo sie durch eine Außenelektrode miteinander verbunden werden, wobei der Aktorgrünkörper gesintert und einer schleifenden Formgebung unterworfen wird und anschließend die Grundmetallisierung für die Außenelektrode aufgebracht wird.

Um eine Isolation (8,12) durch eine keramische Schicht zu erreichen, die nach dem Sintern und der Formgebung durch Schleifen aufgebracht werden kann und somit auch hohen Anforderungen genügt, wird vorgeschlagen, dass zu isolierende Bereiche mittels Dickschichtverfahren mit einer Paste, bestehend auf einem anorganischen, niedrigsinternden Material oder einer Materialmischung und einem organischen Bindersystem beschichtet und anschließend einem Einbrennvorgang unterworfen werden, wobei die Schichtdicke nach dem Sintern zwischen 1 und 40 µm, bevorzugt zwischen 2 und 20 µm oder zwischen 4 und 15 µm liegt.

## Beschreibung

Die Erfindung betrifft ein Verfahren zur Herstellung piezoelektrischer Vielschichtaktoren - nachfolgend Aktoren genannt - nach dem Oberbegriff des Anspruchs 1 und einen Aktor hergestellt nach diesem Verfahren

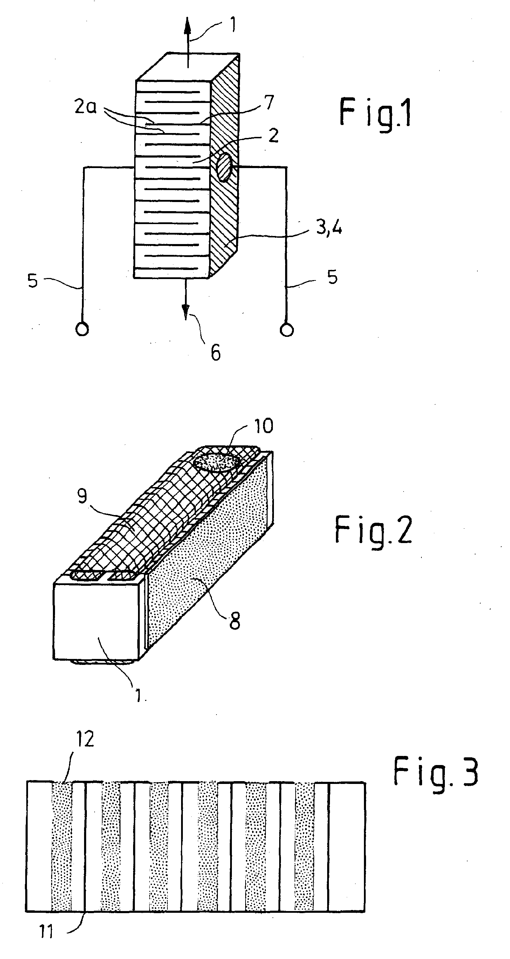

Piezokeramische Vielschichtaktoren (siehe Fig. 1) nach dem Stand der Technik bestehen aus gestapelten dünnen Schichten piezoelektrisch aktiven Materials 2, z. B. Blei-Zirkonat-Titanat (PZT), mit dazwischen angeordneten leitfähigen Innenelektroden 7, die alternierend an die Aktoroberfläche geführt werden. Außenelektroden 3, 4 verbinden diese Innenelektroden. Dadurch werden die Innenelektroden elektrisch parallel geschaltet und zu zwei Gruppen zusammengefasst, welche die beiden Anschlusspole des Aktors darstellen. Legt man eine elektrische Spannung an die Anschlusspole, so wird diese auf alle Innenelektroden parallel übertragen und verursacht ein elektrisches Feld in allen Schichten aktiven Materials, das sich dadurch mechanisch verformt. Die Summe aller dieser mechanischen Verformungen steht an den Endflächen des Aktors als nutzbare Dehnung 6 und/oder Kraft zur Verfügung.

Piezokeramische Vielschichtaktoren werden nach dem Stand der Technik als Monolithen ausgeführt, das heißt, das aktive Material wird als sogenannte Grün-Folie vor dem Sintern durch ein Siebdruckverfahren mit Innenelektroden versehen, zu Aktorstapeln verpresst, pyrolysiert und dann gesintert, wodurch der monolithische Aktor entsteht.

Auf den Aktorstapel 1 wird im Bereich der herausgeführten Innenelektroden 7, z. B. durch Siebdruck von Metallpaste, eine Grundmetallisierung 3 aufgebracht. Diese Grundmetallisierung wird verstärkt durch Aufbringen eines metallischen Werkstoffes 4, z. B. durch Anlöten eines strukturierten Bleches oder eines Drahtnetzes. An diese verstärkte Schicht wird der elektrische Anschlussdraht 5 gelötet.

Der Aufbau und die Herstellung derartiger Aktoren und Außenelektroden wird ausführlich beschrieben z. B. in DE 33 30 538 A1, DE 40 36 287 C2, US 5 281 885, US 4 845 399, US 5 406 164 und JP 07-226541 A.

Der Abstand der interdigital nach außen führenden Innenelektroden 2a verschiedener Polarität ist so gering, dass bei Betriebsspannung ein Überschlag an der Oberfläche erfolgen würde. Daher wird üblicherweise die Oberfläche durch einen Isolierlack bedeckt. Nachteilig wirkt sich hier aus, dass dünne Lacke nur einen unzureichenden Berührschutz bieten und mechanisch anfällig sind. Dicke Lacke hingegen neigen zur Ablösung im Betrieb oder unter Temperaturwechselbeanspruchung. Mit interdigitalen Bereichen sind die nach außen führenden Innenelektroden 2a in Fig. 1 zwischen den kontaktierten Seiten 3, 4 verstanden.

Eine andere Möglichkeit besteht darin, die Elektroden nicht bis ganz an die Oberfläche treten zu lassen ("vergrabene Elektroden") oder nur Elektroden einer Polarität an die Oberfläche treten zu lassen ("halbvergrabene Elektroden"). Der Nachteil liegt darin, dass die aktive Fläche verkleinert wird und damit die Kraftentfaltung des Aktors verringert wird. Gleichzeitig bedingen diese inaktiven Zonen eine Klemmung des Aktors und sind anfällig für Risse.

Eine weitere Möglichkeit die Oberfläche zu schützen besteht darin, auf die grüne Oberfläche des Aktors eine keramische Folie aufzubringen, diese mit dem Aktor zu versintern um so eine Isolation zu erreichen (DE10 021 919 A1). Nachteilig bei diesem Verfahren ist, dass die Außenmasse des Aktors durch die Sinterschrumpfung bedingt nicht sehr genau zu reproduzieren sind. Außerdem ist diese Isolierschicht verfahrensbedingt relativ dick (typisch >50µm) und hat somit ähnliche Nachteile wie die beiden zuvor genannten Verfahren.

Der Erfindung liegt die Aufgabe zu Grunde, eine Isolation durch eine keramische Schicht zu erreichen, die nach dem Sintern und der Formgebung durch Schleifen, aufgebracht werden kann und somit auch hohen geometrischen Anforderungen genügen kann.

Erfindungsgemäß wird diese Aufgabe durch die Merkmale des Anspruchs 1 gelöst.

Vorteilhafterweise erfolgt die Beschichtung nach dem Sintern und der Formgebung und wird die Beschichtung bei Temperaturen zwischen 400 und 1.200 °C oder zwischen 600 und 1.000 °C oder bevorzugt zwischen 650 und 850 °C eingebrannt.

Bevorzugt erfolgt das Einbrennen der Isolierschicht gemeinsam mit dem Einbrennen der Außenelektrode und bildet eine durchgehende Schicht.

In einer alternativen Ausführungsform erfolgt das Aufbringen der Isolierschicht nach der Polarisation des Aktors und erfolgt durch Trocknen bei 20 bis 250 °C bevorzugt bei 80 bis 120 °C eine Bedeckung aller Elektroden einer Polarität, aber keine Bedeckung der Elektroden der anderen Polarität und somit wird keine durchgehende Schicht ausgebildet.

Bevorzugt ist das niedrig sinternde Material PZT (Blei-Zirkonat-Titanat) und/oder ist identisch mit dem Aktormaterial.

Vorteilhafterweise besteht die Dickschichtpaste aus einem Glas und einem organischen Bindersystem.

Bevorzugt wird die Dickschichtpaste auf den grünen Aktorkörper aufgebracht und gemeinsam mit diesem gesintert.

In vorteilhafter Ausgestaltung wird die Dickschicht mittels Siebdruck, Tampondruck oder Walzen oder durch Plasmaspritzen aufgebracht.

Ein Aktor der nach dem erfindungsgemäßen Verfahren hergestellt ist, dient vorteilhaft zur Regelung eines Einspritzventils in Kraftfahrzeugen.

Weitere Merkmale der Erfindung ergeben sich aus den Figuren und den Ausführungsbeispielen, die nachfolgend beschrieben sind.

Die zu isolierenden Flächen werden mittels Dickschichtverfahren mit einer aus niedrigsinterndem PZT (z. B. aus DE 19 840 488 A1 bekannt) und einem organischen Bindersystem bestehenden Paste beschichtet. Diese Isolierschicht wird bei Temperaturen zwischen 500 und 1200°C, bevorzugt zwischen 600 und 900°C eingebrannt.

In einer weiteren Ausführungsform ist der Aktor vor dem Aufbringen der Siebdruckschicht bereits polarisiert, so dass sich beim Trocknen der Paste bei 80-120°C eine Pyrospannung ergibt. Diese Pyrospannung führt aufgrund von elektrophoretischen Vorgängen dazu, dass nur jede zweite Elektrode von PZT-Partikeln bedeckt wird. Hierdurch ist nach dem Sintern eine hervorragende Isolation der Elektroden unterschiedlicher Polarität gewährleistet, ohne dass die Oberfläche mit einer zusammenhängenden Schicht bedeckt ist, die die Ausdehnung oder die Kraftentfaltung des Aktors behindert.

### Ausführungsbeispiele:

Der Aktor wird wie üblich so aufgebaut, dass die Elektroden allseitig interdigital nach außen geführt werden, nur an den zu kontaktierenden Flächen nicht. Der Aktorgrünkörper wird gesintert und kann einer schleifenden Formgebung hoher Präzision unterworfen werden. Anschließend kann die Grundmetallisierung für die Außenelektrode (Kontaktierung von Elektroden einer Polarität) mittels Siebdruck aufgebracht werden.

Verfahren 1: Die Isolierschicht 8 wird mittels Dickschichtverfahren gemeinsam mit den Außenelektrodenschichten (Grundmetallisierung) aufgebracht und gemeinsam eingebrannt (600<TS<900°C). Die Isolierschicht bedeckt nun die gesamten interdigitalen Bereiche 8 des Aktors mit einer zwischen 2 und 20µm, bevorzugt 4-15µm dicken Schicht. Diese ist haft- und kratzfest und behindert die Auslenkung beziehungsweise die Kraftentfaltung des Aktors nur unwesentlich (Fig. 2). Anschließend wird die Außenelektrode mit einem Sieb 9 verlötet und weiterkontaktiert 10. Figur 2 zeigt einen Aktor mit Außenelektroden und Isolierung mittels Siebdruck (ganzflächig).

Verfahren 2: Die Außenelektrode (Grundmetallisierung) wird eingebrannt. Der Aktor wird anschließend polarisiert und an den Oberflächen, die eine interdigitale Struktur aufweist, wird mittels Siebdruck eine Paste bestehend aus niedrigsinterndem PZT und einem organischen Bindersystem aufgebracht. Beim Trocknen der Paste bei 20-250°C, bevorzugt bei 80-120°C wird durch den pyroelektrischen Effekt der ferroelektrischen Keramik in der noch nicht getrockneten Paste ein elektrisches Feld erzeugt. Hierdurch kommt es zu elektrophoretischen Vorgängen in der Paste, so dass nur jede zweite Innenelektrode von Keramikpartikeln bedeckt wird (Elektroden einer Polarität, Fig. 3, Nr. 12). Die Elektroden 11 der anderen Priorität werden nicht bedeckt. Ein anschließender Einbrennvorgang bei Temperaturen um 750°C führt zu einer haft.- und kratzfesten Isolation (Fig. 3). Figur 3 zeigt die Isolierfläche eines Aktors mit Innenelektroden 11 und Isolierung 12 jeder zweiten Innenelektrode mittels Siebdruck (unterbrochen).

## Patentansprüche

1. Verfahren zur Herstellung piezoelektrischer Vielschichtaktoren, bei dem dünne Schichten aus einem piezokeramischen Werkstoff, Grünfolien genannt, auf die mindestens eine Innenelektrode aufgebracht sind, so zu einem Block aufeinandergestapelt werden, dass die Innenelektroden alternierend an sich gegenüberliegenden Flächen des Aktors geführt werden, wo sie durch eine Außenelektrode miteinander verbunden werden, wobei der Aktorgrünkörper gesintert und einer schleifenden Formgebung unterworfen wird und anschließend die Grundmetallisierung für die Außenelektrode aufgebracht wird, **dadurch gekennzeichnet, dass** zu isolierende Bereiche mittels Dickschichtverfahren mit einer Paste, bestehend aus einem anorganischen, niedrigsinternden Material oder einer Materialmischung und einem organischen Bindersystem beschichtet und anschließend einem Einbrennvorgang unterworfen werden, wobei die Schichtdicke nach dem Sintern zwischen 1 und 40 µm, bevorzugt zwischen 2 und 20 µm oder zwischen 4 und 15 µm liegt.

2. Verfahren nach Anspruch 1, **dadurch gekennzeichnet, dass** die Beschichtung nach dem Sintern und der Formgebung erfolgt und die Beschichtung bei Temperaturen zwischen 400 und 1.200°C, oder 600 und 1.000°C besonders bevorzugt zwischen 650 und 850°C eingebrannt wird.

3. Verfahren nach Anspruch 1 oder 2, **dadurch gekennzeichnet, dass** das Einbrennen der Isolierschicht gemeinsam mit dem Einbrennen der Außenelektrode erfolgt und eine durchgehende Schicht bildet.

4. Verfahren nach Anspruch 1 oder 2, **dadurch gekennzeichnet, dass** das Aufbringen der Isolierschicht nach der Polarisation des Aktors erfolgt und durch Trocknen bei 20 - 250°C, bevorzugt bei 80 - 120°C eine Bedeckung aller Elektroden einer Polarität, aber keine Bedeckung der Elektroden der anderen Polarität erfolgt und somit keine durchgehende Schicht ausgebildet wird.

5. Verfahren nach einem der Ansprüche 1 bis 4, **dadurch gekennzeichnet, dass** das niedrigsinternde Material PZT ist und/oder identisch mit dem Aktormaterial ist.

6. Verfahren nach einem der Ansprüche 1 bis 4, **dadurch gekennzeichnet, dass** die Dickschichtpaste aus einem Glas und einem organischen Bindersystem besteht.

7. Verfahren nach einem der Ansprüche 1 bis 6, **dadurch gekennzeichnet, dass** die Dickschichtpaste auf den grünen Aktorkörper aufgebracht wird und gemeinsam mit diesem gesintert wird.

8. Verfahren nach einem der vorhergehenden Ansprüche, **dadurch gekennzeichnet, dass** die Dickschicht mittels Siebdruck aufgebracht wird.

9. Verfahren nach einem der vorhergehenden Ansprüche, **dadurch gekennzeichnet, dass** die Dickschicht mittels Tampondruck oder Walzen aufgebracht wird.

10. Verfahren nach einem der vorhergehenden Ansprüche, **dadurch gekennzeichnet, dass** die Dickschicht mittels Plasmaspritzen aufgebracht wird.

11. Aktor hergestellt nach einem Verfahren nach den Ansprüchen 1 bis 10.

12. Aktor nach Anspruch 11, **dadurch gekennzeichnet, dass** der Aktor zur Regelung eines Einspritzventils dient.
